(19) Europäisches Patentamt

European Patent Office

Office européen des brevets

(11) **EP 0 872 571 A1**

(12) **EUROPÄISCHE PATENTANMELDUNG**

(43) Veröffentlichungstag:
21.10.1998 Patentblatt 1998/43

(51) Int. Cl.$^6$: **C23C 14/34**, C04B 35/547

(21) Anmeldenummer: 98105253.3

(22) Anmeldetag: 24.03.1998

(84) Benannte Vertragsstaaten:
AT BE CH DE DK ES FI FR GB GR IE IT LI LU MC
NL PT SE
Benannte Erstreckungsstaaten:
AL LT LV MK RO SI

(30) Priorität: 16.04.1997 DE 19715806

(71) Anmelder: LEYBOLD MATERIALS GmbH
D-63450 Hanau (DE)

(72) Erfinder:
• Schlott, Martin, Dr.
  63075 Offenbach (DE)
• Dauth, Wolfgang
  60594 Frankfurt am Main (DE)
• Kutzner, Martin
  63543 Neuberg (DE)

(54) **Verfahren zur Herstellung eines Sputtertargets auf der Basis von Zinksulfid sowie das Sputtertarget selbst**

(57) Bei einem Sputtertarget für Kathodenzerstäubungsanlagen auf der Basis von Zinksulfid (ZnS) mit einem $SiO_2$-Zusatz und mit einer Dichte von mindestens 90% der theoretischen Dichte (d. h. mindestens 3,3 g/cm$^3$ für $ZnS/SiO_2$ 80/20) ist das Gefüge überwiegend in der Sphalerit-Modifikation enthalten, wobei das Pulver bei Temperaturen unterhalb von 1200°C über Heißpressen oder bei Temperaturen unterhalb 1100°C heißisostatisch verdichtet.

EP 0 872 571 A1

## Beschreibung

Die Erfindung betrifft Verfahren zur Herstellung eines Sputtertargets auf der Basis von Zinksulfid (ZnS), das noch weitere Zusätze, wie z. B. $SiO_2$ enthalten kann, zum Einsatz bei Kathodenzerstäubungsanlagen sowie das Sputtertarget selbst.

Zinksulfid-Targets werden üblicherweise eingesetzt, um über Kathodenzerstäubung dielektrische Schichten abzuscheiden. Diese Schichten werden z. B. eingesetzt bei wiederbeschreibbaren optischen Speicherdisks, die nach dem Phase-Change-Prinzip arbeiten (E. Ohno et al., US-Patent 5,289,453 und H. Iwasaki et al., Jap. J. Appl. Phys. Vol. 31 (1992), part 1, No. 2B, 461-465). In der Technik geläufig sind für diese Anwendung Schichten mit etwa 20 Mol% $SiO_2$.

Aufgabe der vorliegenden Erfindung ist es, Targetplatten mit einer Dichte von mindestens 90% der theoretischen Dichte (d. h. mindestens 3,3 g/cm$^3$ für ZnS/$SiO_2$ 80/20) Mol% und mindestens 3,7 g/cm$^3$ für reines ZnS) auf einem pulvermetallurgischen Weg herzustellen. Die Reinheit sollte mindestens 99,9 % betragen.

Diese Aufgabe wird erfindungsgemäß dadurch gelöst, daß das Target eine Dichte von mindestens 90% seiner theoretischen Dichte besitzt und ein Gefüge ZnS überwiegend in der Sphalerit-Modifikation enthält.

Vorzugsweise weisen die mit Kupfer K$\alpha$-Strahlung gemessenen Röntgendiffraktometer-Aufnahmen folgende Verhältnisse für die Intensität I(100-W) des (100) Peaks der Wurtzit-Modifikation bei 2$\theta$ = 26,9° sowie die Intensität I(002-W/111-S) des Peaks bei 2$\theta$ = 28,6° (Summe des (002) Peaks der Wurtzit-Modifikation sowie des (111) Peaks der Sphalerit-Modifikation) auf.

Zweckmäßigerweise sind dem ZnS zwischen 10 und 30 Mol% $SiO_2$ sowie gegebenenfalls noch weitere Zusätze beigemischt, wobei das $SiO_2$ in Form kantiger Körper vorliegt.

Erfindungsgemäß weist das Verfahren zur Herstellung eines Sputtertargets ein ZnS-Pulver mit überwiegender Sphalerit-Modifikation auf. Mit Vorteil wird das Pulver bei Temperaturen verdichtet, die die Entstehung der Wurtzit-Hochtemperaturmodifikation weitgehend verhindern.

Vorzugsweise wird das Pulver bei Temperaturen unterhalb 1200°C über Heißpressen verdichtet, wobei die Abkühlung anfangs nicht schneller als mit 4°C/Minute erfolgt.

Alternativ wird das Pulver über Heißisostatisches Pressen bei Temperaturen unterhalb 1100°C verdichtet, wobei die Abkühlung anfangs nicht schneller als mit 4°C/Minute erfolgt.

Bei den Untersuchungen zu möglichen Prozeßbedingungen stellten sich zunächst bei kleinen Targetscheiben von 75 bis 100 mm Durchmesser recht schnell Erfolge ein. Aus zunächst unerklärlichen Gründen waren jedoch gewisse ZnS-Pulver geeignet, während andere Pulver grundsätzlich zu rissigen Körpern führten. Es wurden sowohl erfolgreiche Versuche zum Heißpressen als auch zum heißisostatischen Pressen durchgeführt. Beim Hochskalieren der Prozesse auf Targetdimensionen für Sputterkathoden in Produktionsgröße (z. B. Scheiben mit 200 mm Durchmesser) ergaben sich dann jedoch zunächst stets Körper, die sowohl große Risse sowie außerdem eine Vielzahl von Mikrorissen enthielten. Daraufhin angestellte detaillierte Untersuchungen der Ausgangspulver sowie der Preßteile ergaben dann, daß das Target immer dann gerissen war, wenn ein ZnS-Ausgangspulver in Wurtzit-Struktur eingesetzt wurde (Bild 1) bzw. wenn die ZnS-Phase des Targetgefüges nach dem Pressen überwiegend in der Wurtzit-Modifikation vorlag. Wurde hingegen ein ZnS-Pulver der Sphalerit-Modifikation eingesetzt (Bild 2) und die Preßtemperatur so gewählt, daß eine Umwandlung in die Wurtzit-Modifikation im wesentlichen verhindert wurde, war das Target makroskopisch und mikroskopisch rißfrei. Zum Vergleich sind die theoretischen Röntgenbeugungsdiagramme für Cu K$\alpha$-Strahlung in den Bildern 6a,b wiedergegeben. Während in der Literatur (Römpps Chemie-Lexikon, 8. Auflage, S. 4714) 1020°C für die Sphalerit-Wurtzit-Umwandlung angegeben werden, haben eigene Untersuchungen ergeben, daß Pressungen bis zu Temperaturen von 1180°C noch zu einem rißfreien Target mit von der Sphalerit-Modifikation dominiertem Gefüge führen, wenn die Preßzeit nur ausreichend kurz und die Abkühlung anfangs nur ausreichend langsam gewählt wird. Geeignete Prozeß-Parameter sind in den Ausführungsbeispielen zu finden.

Des weiteren hat sich in Gefügeuntersuchungen gezeigt, daß die üblicherweise beigemischten $SiO_2$-Körner nur schlecht mit der ZnS-Matrix verbunden sind. Es ist deshalb anzustreben, $SiO_2$-Pulver mit unregelmäßig geformten Körnern, wie sie z. B. durch mechanisches Mahlen entstehen, einzusetzen. Bei kugeligen Pulvern besteht sonst die Gefahr, daß sich diese beim Sputtern aus dem Target lösen und zu einer erhöhten Partikelrate führen.

Die Erfindung läßt die verschiedensten Ausführungsmöglichkeiten zu; einige davon sind in den nachstehenden Abbildungen und Ausführungsbeispielen näher dargestellt und beschrieben, und zwar zeigen:

Bild 1     ein Röntgenbeugungsdiagramm eines ZnS-Pulvers in Wurtzit-Modifikation, aufgenommen mit Cu K$\alpha$-Strahlung,

Bild 2     ein Röngenbeugungsdiagramm eines ZnS-Pulvers in Sphalerit-Modifikation, aufgenommen mit Cu K$\alpha$-Strahlung,

Bild 3     ein Röntgenbeugungsdiagramm eines ZnS/$SiO_2$-Preßlings entsprechend Beispiel 1, aufgenommen mit Cu K$\alpha$-Strahlung, das Spektrum zeigt überwiegend die Sphalerit-Modifikation,

Bild 4      ein  Röntgenbeugungsdiagramm  eines ZnS/SiO$_2$-Preßlings entsprechend Beispiel 2, aufgenommen mit Cu K$\alpha$-Strahlung, das Spektrum zeigt neben der Sphalerit-Modifikation nur noch geringe Anteile an Wurtzit,

Bild 5      ein  Röntgenbeugungsdiagramm  eines ZnS/SiO$_2$-Preßlings  entsprechend  Vergleichsbeispiel 4, aufgenommen mit Cu K$\alpha$-Strahlung, das Spektrum zeigt ZnS fast ausschließlich in der Wurtzit-Modifikation und

Bild 6      die theoretischen Röntgenspektren für Cu K$\alpha$-Strahlung

a) ZnS-Wurtzit (ASTM Nr. 5-492),
b) ZnS-Sphalerit (ASTM Nr. 5-566).

**Beispiel 1 entsprechend der vorliegenden Erfindung:**

866,5 g ZnS-Pulver in Sphalerit-Modifikation werden mit 133,5 g eines gebrochenen amorphen SiO$_2$-Pulvers naß gemischt, anschließend getrocknet und durch eine Siebagglomeriermaschine gegeben. Das so erhaltene Mischpulver wurde in eine Graphitpreßform mit einem Durchmesser von 250 mm gegeben und unter Schutzgas bei 1180°C für 30 Minuten heißgepreßt. Die Abkühlung auf 800°C erfolgte mit 2°C/Minute, danach wurde die Anlage abgeschaltet. Die Targetscheibe wurde nach Erkalten der Anlage entnommen. Sie wies eine Dichte von 3,4 g/cm$^3$ (93%) auf und war makroskopisch und mikroskopisch rißfrei. Die Röntgenanalyse zeigte überwiegend ZnS in Sphalerit-Modifikation, es waren aber auch Phasenteile der Wurtzit-Modifikation zu erkennen (Bild 3). Das Target wurde angesputtert und untersucht. Es waren keine ausgebrochenen SiO$_2$-Körner erkennbar.

**Beispiel 2 entsprechend der vorliegenden Erfindung:**

Eine Pulvermischung entsprechend Beispiel 1 wurde auf einem Rollenbock trocken gemischt und anschließend in einer Gummiform mit 300 mm Durchmesser kaltisostatisch gepreßt. Der so erhaltene Grünkörper wurde in eine zylindrische Stahlkapsel gesetzt, die anschließend evakuiert und verschlossen wurde. Die Kanne wurde durch heißisostatisches Pressen bei 1050°C und einem Druck von 2000 bar verdichtet. Die Abkühlung erfolgte bis 800°C mit 4°C/Minute. Nach dem Entkapseln wies der Körper eine Dichte von 3,6 g/cm$^3$ (98%) auf und war makroskopisch und mikroskopisch rißfrei. Die Röntgenphasenanalyse zeigte fast ausschließlich ZnS in Sphalerit-Modifikation. Es waren nur sehr geringe Wurtzit-Anteile erkennbar (Bild 4). Das Target wurde angesputtert und untersucht. es waren keine ausgebrochenen SiO$_2$-Körner erkennbar.

**Beispiel 3 entsprechend der vorliegenden Erfindung:**

1000 g eines ZnS-Pulvers in Sphalerit-Modifikation wurden in einer Gummiform mit 300 mm Durchmesser kaltisostatisch gepreßt. Der so erhaltenen Grünkörper wurde in eine zylindrische Stahlkapsel gesetzt, die anschließend evakuiert und verschlossen wurde. Die Kanne wurde durch heißisostatisches Pressen bei 950°C und einem Druck von 2000 bar verdichtet. Nach dem Entkapseln wies der Körper eine Dichte von 3,9 g/cm$^3$ (95%) auf. Der Körper war makroskopisch und mikroskopisch rißfrei. Die Röntgenphasenanalyse zeigte ZnS-Pulver in Sphalerit-Modifikation (Bild 2).

**Vergleichsbeispiel 4:**

Eine entsprechend Beispiel 1 hergestellte Pulvermischung wurde in eine Graphitpreßform mit einem Durchmesser von 250 mm gegeben und unter Schutzgas bei 1350°C für 40 Minuten heißgepreßt. Die Abkühlung auf 600°C erfolgte mit 10!C/Minute, danach wurde die Anlage abgeschaltet. Die Targetscheibe wurde nach Erkalten der Anlage entnommen. Sie wies eine dichte von 3,6 g/cm$^3$ auf (98%) und zeigte sowohl makroskopische als auch mikroskopische Risse. Die Röntgenphasenanalyse zeigte ZnS fast ausschließlich in Wurtzit-Modifikation (Bild 5).

**Vergleichsbeispiel 5:**

866,5 g ZnS-Pulver in Wurtzit-Modifikation wurden mit 133,5 g eines gebrochenen amorphen SiO$_2$-Pulvers naß gemischt, anschließend getrocknet und durch eine Siebagglomeriermaschine gegeben. Von dem so erhaltenen Mischpulver wurden 300 g in einem Graphitpreßform mit einem Durchmesser von 100 mm gegeben und unter Schutzgas bei 1150°C für 30 Minuten heißgepreßt. Die Abkühlung auf 600°C erfolgte mit 4°C/Minute. Die Targetscheibe wurde nach Erkalten der Anlage entnommen. Sie wies eine Dichte von 3,6 g/cm$^3$ (98%) auf. Sie bestand aus mehreren Bruchstücken, die auch mikroskopisch noch weitere Risse aufwiesen. Die Röntgenphasenanalyse zeigte ZnS in Wurtzit-Modifikation.

**Vergleichsbeispiel 6:**

900 g ZnS-Pulver in Sphalerit-Modifikation wurden mit 100 g eines kugeligen SiO$_2$-Pulvers naß gemischt, anschließend getrocknet und durch eine Siebagglomeriermaschine gegeben. Die weitere Targetherstellung erfolgte wie in Beispiel 1. Das Target war wieder Rißfrei und enthielt ZnS überwiegend in Sphalerit-Modifikation. Schon bei der Schliffpräparation zeigten sich zahlreiche kugelförmige Ausbrüche, die auf herausgefallene SiO$_2$-Körner zurückzuführen waren. Dasselbe Phänomen konnte auch an angesputterten Targets beobachtet werden.

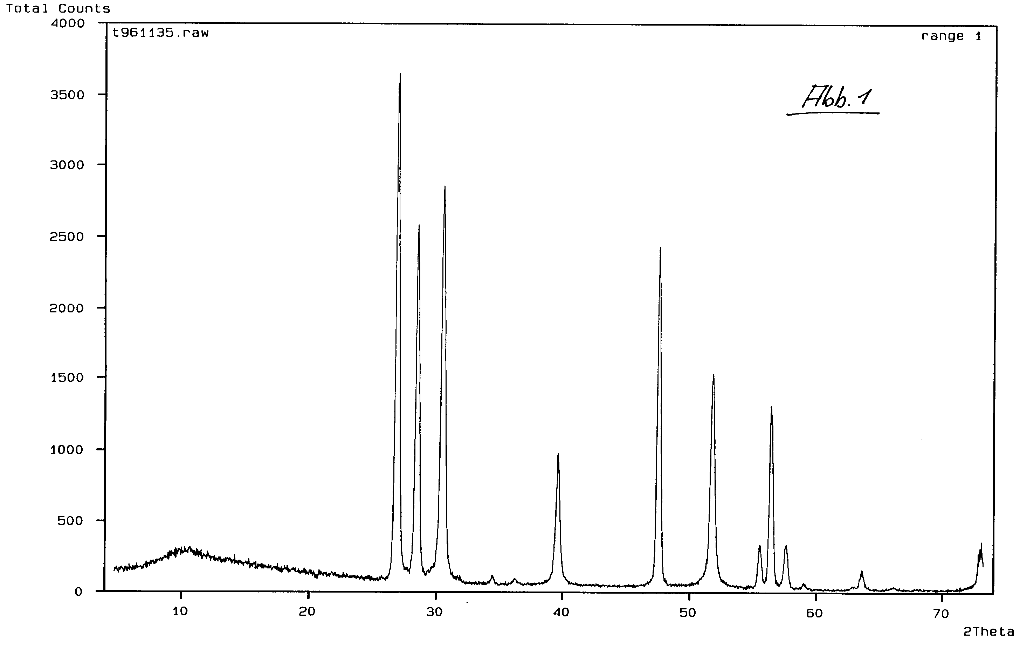

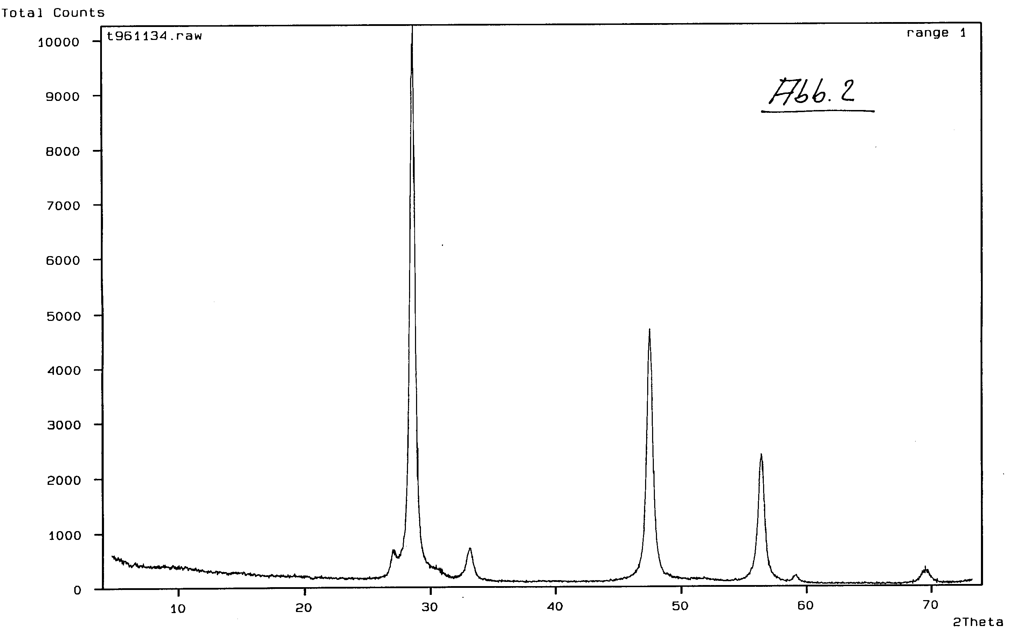

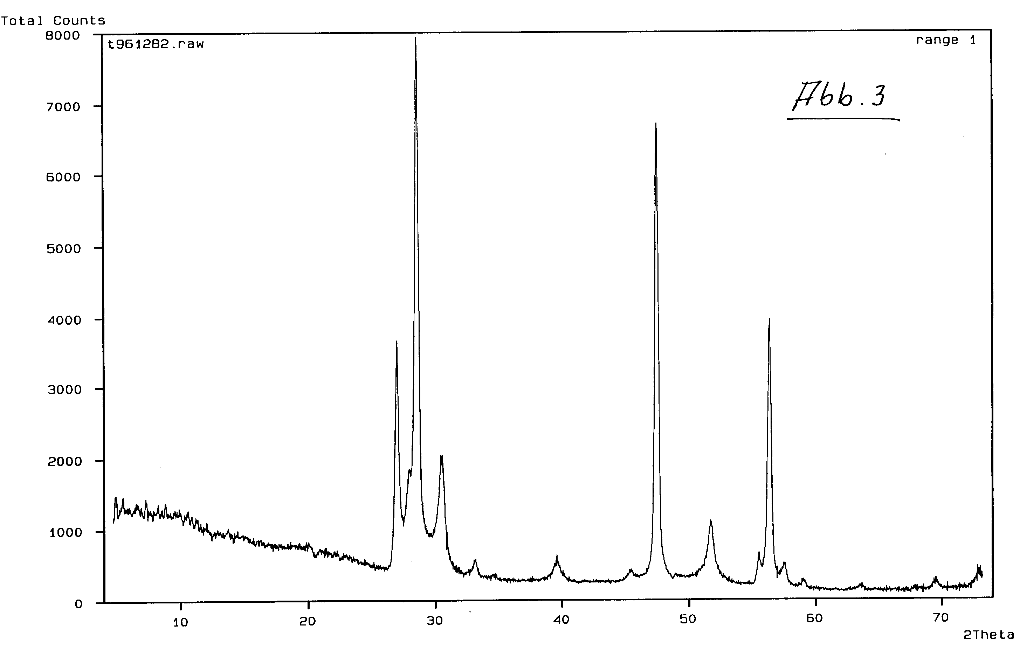

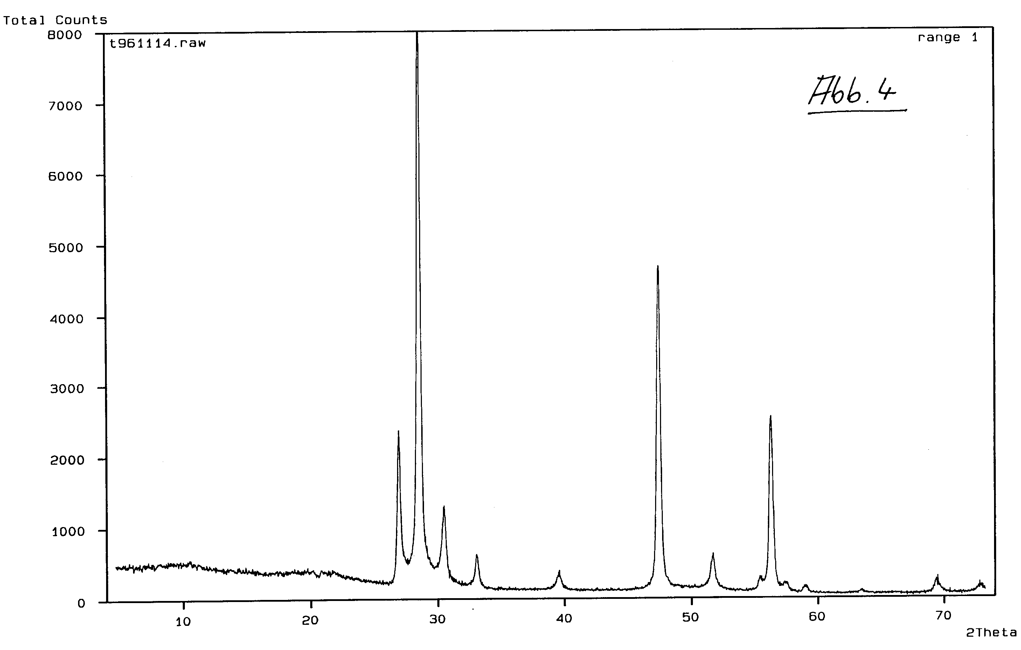

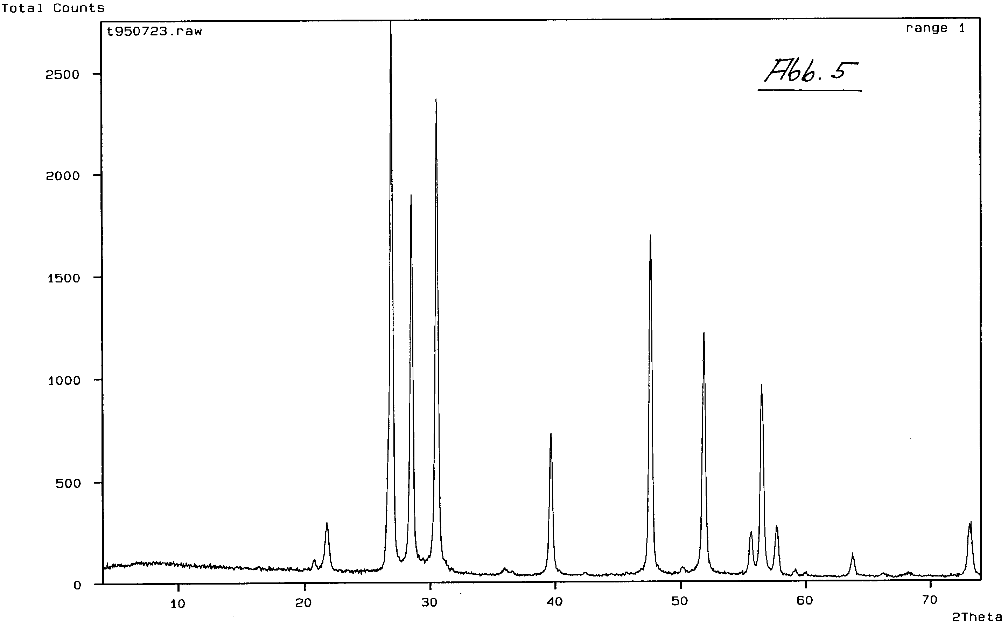

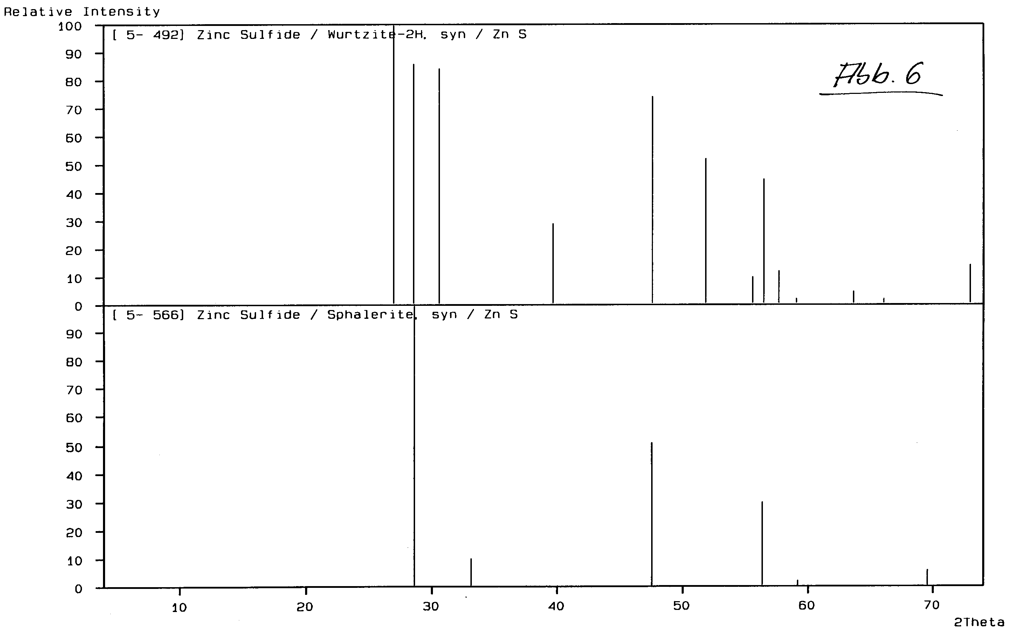

**Patentansprüche**

1. Sputtertarget mit mindestens 70 Mol% ZnS (mit gegebenenfalls weiteren Zusätzen) zum Einsatz in der Kathodenzerstäubung, **dadurch gekennzeichnet**, daß das Target eine Dichte von mindestens 90% seiner theoretischen Dichte besitzt und das gefüge ZnS überwiegend in der Sphalerit-Modifikation enthält.

2. Sputtertarget gemäß Anspruch 1, **dadurch gekennzeichnet**, daß die mit Kupfer K$\alpha$-Strahlung gemessenen Röntgendiffraktometer-Aufnahmen folgende Verhältnisse für die Intensität I(100-W) des (100) Peaks der WurtzitModifikation bei $2\theta =$ 26,9° sowie die Intensität I(022-W/111-S) des Peaks bei $2\theta = 28,6°$ (Summe des (002) Peaks der Wurtzit-Modifikation sowie des (111) Peaks der Sphalerit-Modifikation) aufweisen:

$$\frac{I(100\text{-}W)}{I(002\text{-}W/111\text{-}S)} < 0,5$$

3. Sputtertarget gemäß Anspruch 1 oder 2, **dadurch gekennzeichnet**, daß dem ZnS zwischen 10 und 30 Mol% $SiO_2$ sowie gegebenenfalls noch weitere Zusätze beigemischt sind.

4. Sputtertarget gemäß Anspruch 3, **dadurch gekennzeichnet**, daß das $SiO_2$ in Form kantiger Körper vorliegt.

5. Verfahren zur Herstellung eines Sputtertargets gemäß einem der Ansprüche 1 bis 4, **dadurch gekennzeichnet**, daß das eingesetzte ZnS-Pulver überwiegend die Sphalerit-Modifikation aufweist.

6. Verfahren zur Herstellung eines Sputtertargets gemäß einem der Ansprüche 1 bis 5, **dadurch gekennzeichnet**, daß das Pulver bei Temperaturen verdichtet wird, die die Entstehung der Wurtzit-Hochtemperaturmodifikation weitgehend verhindern.

7. Verfahren zur Herstellung eines Sputtertargets gemäß einem der Ansprüche 1 bis 6, **dadurch gekennzeichnet**, daß das Pulver bei Temperaturen unterhalb 1200°C über Heißpressen verdichtet wird.

8. Verfahren entsprechend Anspruch 7, **dadurch gekennzeichnet**, daß die Abkühlung anfangs nicht schneller als mit 4°C/Minute erfolgt.

9. Verfahren zur Herstellung eines Sputtertargets gemäß einem der Ansprüche 1 bis 6, **dadurch gekennzeichnet**, daß das Pulver über Heißisostatisches Pressen bei Temperaturen unterhalb 1100°C erfolgt.

10. Verfahren entsprechend Anspruch 9, **dadurch gekennzeichnet**, daß die Abkühlung anfangs nicht schneller als mit 4°C/Minute erfolgt.

Total Counts

t961135.raw

range 1

Abb. 1

2Theta

EP 0 872 571 A1

Total Counts

Fb6.2

EP 0 872 571 A1

Total Counts

EP 0 872 571 A1

t961282.raw                                                    range 1

Abb.3

EP 0 872 571 A1

Total Counts

t950723.raw

range 1

*Abb. 5*

2500

2000

1500

1000

500

0

10    20    30    40    50    60    70

2Theta

EP 0 872 571 A1

Relative Intensity

*Abb. 6*

EP 0 872 571 A1

Europäisches Patentamt

**EUROPÄISCHER RECHERCHENBERICHT**

Nummer der Anmeldung

EP 98 10 5253

## EINSCHLÄGIGE DOKUMENTE

| Kategorie | Kennzeichnung des Dokuments mit Angabe. soweit erforderlich, der maßgeblichen Teile | Betrifft Anspruch | KLASSIFIKATION DER ANMELDUNG (Int.Cl.6) |
|---|---|---|---|
| Y | COLLINS B T ET AL: "PREPARATION AND PHOTOLUMINESCENCE OF THULIUM-ACTIVATED ZINC SULFIDE FILMS" JOURNAL OF THE ELECTROCHEMICAL SOCIETY, Bd. 138, Nr. 11, 1.November 1991, Seiten 3515-3518, XP000325088 *EXPERIMENTAL* | 1,2,5,6 | C23C14/34 C04B35/547 |
| Y | DATABASE WPI Section Ch, Week 9351 Derwent Publications Ltd., London, GB; Class L02, AN 93-410696 XP002071741 & JP 05 310 467 A (DOWA MINING CO LTD) * Zusammenfassung * | 1,2,5,6 | |
| A | BUNTON G V ET AL: "Epitaxial thin films of ZnS and GaAs prepared by r.f. sputtering on NaCl substrates" THIN SOLID FILMS, APRIL 1972, SWITZERLAND, Bd. 10, Nr. 1, ISSN 0040-6090, Seiten 11-20, XP002071740 * Seite 13, Zeile 9 - Zeile 17 * | 1-10 | |
| A | PATENT ABSTRACTS OF JAPAN vol. 009, no. 134 (C-285), 8.Juni 1985 & JP 60 021372 A (MATSUSHITA DENKI SANGYO KK), 2.Februar 1985, * Zusammenfassung * | 1-10 | |
| A | EP 0 706 176 A (TORAY INDUSTRIES) 10.April 1996 * Seite 7, Zeile 14 - Zeile 21 * | 3,4 | |

RECHERCHIERTE SACHGEBIETE (Int.Cl.6)

C23C
C04B

Der vorliegende Recherchenbericht wurde für alle Patentansprüche erstellt

| Recherchenort | Abschlußdatum der Recherche | Prüfer |
|---|---|---|
| DEN HAAG | 17.Juli 1998 | Ekhult, H |